# DEMANDE DE BREVET EUROPEEN

(11) **EP 2 263 983 A1**
(43) Date de publication de la demande: **22.12.2010**
(21) Numéro de dépôt: 09162021.1
(22) Date de dépôt: 05.06.2009
(51) Int. Cl.: C03C 17/23

(54) **Procédé et installation pour le dépôt de couches sur un substrat.**

(71) Demandeur: AGC Glass Europe, 1170 Bruxelles (Watermael-Boitsfort) (BE)
(72) Inventeur: La désignation de l'inventeur n'a pas encore été déposée
(74) Mandataire: Vandeberg, Marie-Paule L.G.

(57) **Abrégé**

L'invention vise à réaliser des dépôts de couches de grandes qualités et de nature variée sur un substrat en combinant l'utilisation d'une phase gazeuse contenant un ou plusieurs précurseurs avec l'utilisation de la post-décharge d'un plasma microondes dans une gamme de pression proche de la pression atmosphérique.

Le substrat est de type verrier inorganique ou de tout autre type pour autant que le substrat revêtu soit utilisé pour des applications utilisant un substrat verrier inorganique.

L'invention permet que la réalisation des dépôts de couches soit possible quelles que soient les conditions imposées par différents types de fabrications, et notamment pour des substrats de différentes dimensions, de différentes natures, de différentes épaisseurs et températures, pour des natures de couches différentes, etc.

En particulier, des dépôts de couche de Si02 ont été réalisés sur des substrats verriers, à l'aide de précurseurs qui n'auraient pas pu être utilisés par CVD classique dans la gamme de température étudiée.

## Description

### DOMAINE DE L'INVENTION

L'invention se rapporte à un procédé pour le dépôt de couches sur un substrat verrier inorganique afin d'en modifier les propriétés et à un procédé pour le dépôt de couches sur tout type de substrat non verrier pour autant que ledit substrat revêtu soit utilisé pour des applications utilisant des substrats verriers inorganiques, comme les applications d'affichage (display) et les cellules photovoltaïques.

L'invention se rapporte aussi à une installation permettant d'appliquer les procédés en question, notamment en continu.

### ETAT DE LA TECHNIQUE

Différents procédés sont utilisés pour déposer des revêtements en couches minces sur des substrats divers. Ils se différencient notamment par la façon dont l'énergie est engendrée pour la production et/ou la liaison au support des composés souhaités.

Les dépôts de revêtements en couches minces touchent diverses applications, comme l'électronique, les revêtements anti-corrosion et tribologiques tels que les couches réfractaires (nitrures, carbures et oxydes de titane ou d'aluminium), les revêtements à propriétés optiques (anti-réfléchissants, anti-solaires, filtres, ..), les revêtements procurant d'autres propriétés de surface particulières(anti-microbienne,auto-nettoyante, hydrophile, hydrophobe, ...),les couches d'oxyde d'étain conductrices pour applications diverses (photovoltaïques, LED, OLED, organique photovoltaïque...) .

Les substrats concernés peuvent être de divers types : verre, acier, céramique, polymères organiques, thermoplastiques...

On distingue principalement quatre techniques de dépôt de couches minces applicables en particulier dans le domaine verrier : le sol-gel, le magnétron, le spray pyrolytique, et la CVD (Chemical Vapor Deposition).

La CVD consiste à envoyer, sur un substrat chaud, des réactifs chimiques ou précurseurs, préalablement vaporisés et qui se décomposent par pyrolyse au contact du substrat chaud.

Ce procédé est couramment appliqué « on-line » lors de la production du verre flotté. Dans ce mode de production la réaction des précurseurs gazeux s'effectue dans l'enceinte de formation de la feuille de verre ou immédiatement à la sortie de celle-ci de manière à profiter de la température élevée du substrat.

On obtient ainsi des couches minces (de l'ordre de quelques dizaines ou centaines de nm), notamment d'oxydes, de grand intérêt pratique. Les couches obtenues sont denses, d'une grande pureté et généralement très stables chimiquement ainsi que mécaniquement.

Cependant, la gamme de matériaux pouvant être déposés est limitée car il est difficile de trouver des précurseurs volatilisables et qui vont pyrolyser dans la gamme de températures appropriées. En particulier pour déposer en ligne, par CVD, sur un ruban de verre, il faut que les précurseurs pyrolysent dans la gamme de température d'environ 500-750°C. De plus, pour la pratique de la technique CVD dans des conditions satisfaisantes, la réaction des précurseurs avec le substrat doit s'effectuer avec une cinétique suffisante dans les conditions qui sont celles mises en oeuvre dans la production du verre « float » pour obtenir des revêtements ayant une épaisseur et des qualités fonctionnelles permettant de répondre à l'application visée. Le temps de contact entre le substrat et les précurseurs est en effet limité en raison de la vitesse de défilement du verre dans l'installation. Les zones confinées dans lesquelles l'opération est conduite, font que la couche doit se développer en quelques secondes au plus. Par ailleurs la température de réaction est fixée pour l'essentiel par la zone de l'installation dans laquelle la réaction peut être menée. Cette température ne dépasse pas habituellement 750°C.

Indépendamment de la nature du précurseur utilisé et de sa sensibilité à la température de réaction, il est également souhaitable de faciliter la réaction des précurseurs pour améliorer le rendement d'utilisation de ceux-ci et réduire la quantité d'effluents à traiter.

Une possibilité de s'affranchir de la température du substrat et donc d'élargir la gamme des précurseurs utilisables en CVD et, par conséquent, la gamme de matériaux déposables, est de combiner la CVD classique (éventuellement à plus basse température) avec un dispositif plasma.

La littérature rapporte l'utilisation de différentes techniques dans lesquelles les réactions de pyrolyse sont assorties de l'utilisation d'un plasma.

Les modes de développement des plasmas et d'application pour le dépôt de couches minces sont d'une grande variété. Les modes les mieux étudiés se développent dans des atmosphères raréfiées. Ces techniques qui peuvent conduire à des dépôts de grande qualité, sont difficilement exploitables pour la production de couches sur des substrats de grandes dimensions.

La mise en oeuvre de techniques requérant la mise sous vide d'enceintes de grandes dimensions d'une part, et la nécessité de faire circuler le substrat de façon continue dans ces enceintes d'autre part, soulèvent des difficultés pratiques difficilement surmontables de façon économique.

Il y a donc un intérêt croissant de la part des industriels pour transférer les technologies plasma basses pressions vers des technologies plasma fonctionnant dans une gamme de pression proche de la pression atmosphérique.

Pour résoudre ces difficultés, les inventeurs ont cherché à allier les potentialités des procédés de traitement par CVD classique avec les potentialités d'un procédé plasma à pression atmosphérique (APPECVD : *Atmospheric Pressure Plasma Enhanced CVD*). Ainsi, ils proposent d'effectuer le dépôt de couche sur substrat de grandes surfaces, par exemple verrier de type "float", notamment en continu directement sur la ligne de production par une technique de CVD favorisée par l'utilisation de la post-décharge d'un plasma microondes à pression atmosphérique. Il ne s'agit donc pas ici de travailler directement dans le plasma comme c'est le cas dans un procédé DBD mais de travailler en post-décharge du plasma, dans un endroit où il n'y a plus ni ions ni électrons. On parle donc ici de Remote PECVD et le procédé utilisé à pression atmosphérique est donc de type « APRPECVD » (*Atmosperic Pressure Remote Plasma Enhanced CVD*).

Il s'agit donc de faire interagir les espèces fortement réactives créées dans et issues du plasma avec le(s) précurseur(s). Ces espèces contribuent ainsi à la dissociation du précurseur et donc à la réactivité du mélange gazeux.

### RESUME DE L'INVENTION

Un premier but de l'invention est de réaliser des dépôts de couches de grandes qualités et de nature variée sur un substrat verrier inorganique en combinant l'utilisation d'une phase gazeuse contenant un ou plusieurs précurseurs avec l'utilisation de la post-décharge d'un plasma microondes dans une gamme de pression proche de la pression atmosphérique. Le substrat peut également être non verrier pour autant que le substrat revêtu soit utilisé dans des applications utilisant des substrats verriers inorganiques.

Un autre but de l'invention est que la réalisation des dépôts de couches soit possible quelles que soient les conditions imposées par différents types de fabrications, et notamment pour des substrats de différentes dimensions, de différentes natures, de différentes épaisseurs et températures, pour des natures de couches différentes, etc.

L'objet de l'invention est un procédé pour le dépôt d'une couche sur un substrat verrier inorganique qui comprend les opérations suivantes :
- introduire ou faire défiler un substrat dans une chambre de réaction dans laquelle sont injectés au moins deux flux gazeux ; un des flux gazeux comprenant au moins un précurseur du matériau à déposer ; un autre de ces flux gazeux étant une post-décharge d'un plasma micro-onde obtenue par passage d'un mélange gazeux dans une ou plusieurs cavités résonnantes alimentées par au moins un générateur microonde ; l'ensemble gazeux est dirigé vers le substrat à revêtir.
- adapter les débits et compositions des flux gazeux et/ou la puissance du au moins un générateur micro-onde en début ou en cours de procédé, de façon à obtenir des caractéristiques de réaction optimale ;
- maintenir le substrat dans la chambre durant un laps de temps suffisant pour obtenir une couche d'épaisseur souhaitée.

La présente invention a également pour objet un procédé pour le dépôt d'au moins une couche sur tout type de substrat non verrier qui comprend les opérations suivantes :
- introduire ou faire défiler un substrat dans une chambre de réaction dans laquelle sont injectés au moins deux flux gazeux ; un des flux gazeux comprenant au moins un précurseur du matériau à déposer ; un autre de ces flux gazeux étant une post-décharge d'un plasma micro-onde obtenue par passage d'un mélange gazeux dans une ou plusieurs cavités résonnantes alimentées par au moins un générateur micro-onde ; les deux flux gazeux sont dirigés vers le substrat à revêtir ;
- adapter les débits et compositions des flux gazeux et/ou la puissance du au moins un générateur micro-onde en début ou en cours de procédé, de façon à obtenir des caractéristiques de réaction optimale ;
- maintenir le substrat dans la chambre durant un laps de temps suffisant pour obtenir une couche d'épaisseur souhaitée ;
ledit substrat non verrier revêtu étant utilisé pour des applications utilisant des substrats verriers inorganiques, comme les applications d'affichage (display) et les cellules photovoltaïques.

A la sortie du dispositif de distribution des flux gazeux, au plus la (les) nappe(s) est(sont) homogène(s), au plus la couche sera de bonne qualité.

On notera que les procédés de l'invention sont définis en termes d' « opérations » plutôt que d' « étapes », c'est à dire que la succession des opérations ne s'effectue pas obligatoirement dans l'ordre où elles sont énoncées ci-dessus.

Un premier avantage des procédés de l'invention est que le nombre de cavités résonnantes ainsi que le nombre de générateurs n'est pas limité. Par conséquent, il est possible de créer une nappe gazeuse en post-décharge de très grande dimension ce qui permet le traitement de substrat de très grande dimension.

Un second avantage des procédés de l'invention est qu'il est possible de générer des post-décharges dans une gamme de pressions proche de la pression atmosphérique avec des puissances inférieures à 100 kW par mètre de largeur de substrat, de préférence inférieures à 50 kW par mètre et de manière encore préférée, inférieures à 20 kW par mètre.

Un troisième avantage des procédés selon l'invention est que les espèces actives, générées en post-décharge grâce à l'énergie apportée par le plasma, en interagissant avec les précurseurs permettent, même sur un substrat froid, de déposer des couches de grandes qualités et ce avec des taux de dépôt élevés.

Un quatrième avantage des procédés de l'invention est que l'énergie apportée par le plasma peut être modulée finement, ce qui rend possible le dépôt de couches d'une grande variété de compositions.

Un autre avantage des procédés est qu'ils sont applicables tant sur un substrat conducteur que sur un substrat isolant.

Suivant un mode de réalisation avantageux, les procédés comprennent en outre l'opération suivante : - amener l'atmosphère régnant dans la chambre de réaction à une pression déterminée.

Suivant un mode de réalisation préféré, la chambre est ouverte et comprend une zone d'entrée et une zone de sortie pour le substrat, ce qui permet aux procédés de l'invention de s'intégrer dans une opération de traitement de surface en continu.

Un autre objet de l'invention est une installation de dépôt d'une couche sur un substrat verrier inorganique comprenant une chambre, des moyens de transport et des moyens de support pour introduire un substrat dans la chambre. Au moins un générateur micro-onde alimente une ou plusieurs cavités résonnantes au travers de laquelle (desquelles) un flux gazeux circule. Ce flux gazeux constituant la post-décharge. Un ou plusieurs autres flux gazeux transportant au moins un précurseur du matériau à déposer est (sont) également injecté(s) dans la chambre mais sans passer au travers des cavités résonnantes. L'ensemble gazeux (post-décharge + précurseurs), sous forme d'une ou plusieurs nappe(s) homogène(s) est dirigé vers le substrat à revêtir. Des moyens de régulation des différents flux gazeux et de contrôle de la puissance du générateur sont prévus, de même que des moyens d'extraction de gaz résiduels.

Suivant un mode de réalisation avantageux, la chambre est ouverte à ses deux extrémités, ce qui permet d'intégrer l'installation de dépôt dans une ligne de production en continu. Dans ce cadre, la chambre peut avantageusement être intégrée dans une ligne de production de verre flotté, les moyens de support du substrat comprenant un bain d'étain.

Suivant un mode de réalisation avantageux, l'installation est intégrée dans une ligne de production qui comprend une galerie de recuisson, la chambre étant placée dans cette galerie de recuisson, les moyens de support du substrat comprenant au moins un rouleau.

Un autre objet de l'invention est une installation de dépôt de couches sur un substrat non verrier pour autant que ledit substrat non verrier revêtu soit utilisé pour des applications utilisant des substrats verriers inorganiques, comme les applications d'affichage (display) et les cellules photovoltaïques.

### BREVE DESCRIPTION DES FIGURES

D'autres avantages et particularités de l'invention ressortiront de la description détaillée ci-après de modes de réalisation particuliers de l'invention, référence étant faite aux figures, dans lesquelles :
la Fig.1 est une vue schématique en élévation, d'une installation de dépôt de couche sur un substrat en verre;
la fig. 2 est une vue schématique en coupe de la partie de l'installation de dépôt dans laquelle circule un ruban de verre. Les dispositifs d'amenée des flux gazeux ainsi que le support du ruban sont également schématisés.

### EXEMPLE DE REALISATION

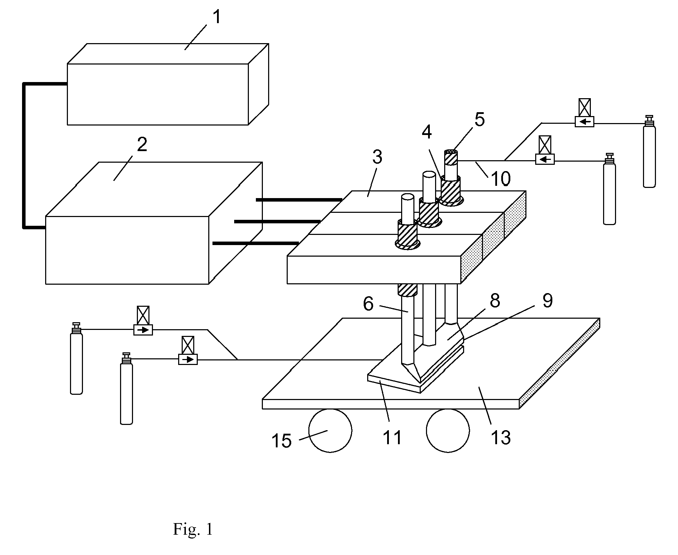

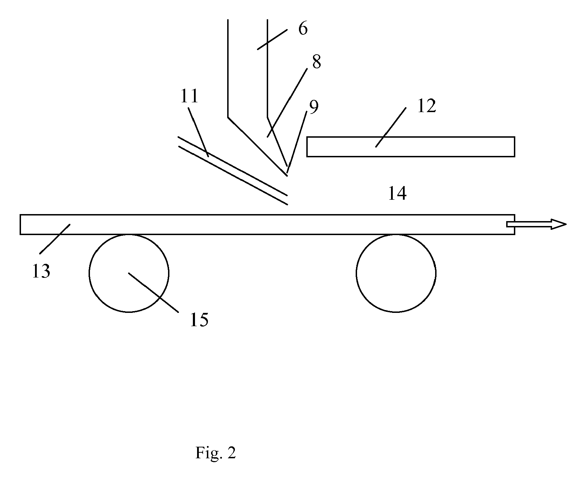

Des dépôts de couches sur substrat verrier sodocalcique ont été réalisés avec le dispositif décrit aux fig. 1 et 2. Le dispositif illustré à la fig. 1 comporte un générateur d'onde 1, relié à un distributeur 2, lui même relié à plusieurs guides d'onde rectangulaires 3. Chaque guide d'onde 3 comporte une cavité résonnante 4 au travers de laquelle un tube de décharge 6 en quartz est inséré. Le tube 6 est alimenté en gaz par l'intermédiaire d'une tête d'injection 5.

Les cavités résonnantes 4 fonctionnent à une fréquence de 2.45 GHz et à pression atmosphérique. Dans l'exemple illustré à la fig. 2, le tube 6 a un diamètre intérieur de 27 mm. Chaque tube de décharge 6 alimente une buse commune 8 dont l'extrémité, dirigée vers le substrat à revêtir 13 est ouverte sous forme d'une fente 9 pour la formation d'une nappe gazeuse homogène.

Une onde stationnaire est générée par le générateur de micro-onde 1 pour obtenir un champ électrique d'intensité maximum dans le tube de décharge 6. La puissance micro-onde absorbée par cavité résonnante varie de 600 à 1000 W selon la puissance incidente fournie et selon la composition des gaz de décharge.

Un ventilateur (non représenté) est utilisé pour centrer le plasma dans le tube de décharge 6 et pour éviter son contact avec les parois du tube.

Les débits des gaz sont contrôlés par des débitmètres massiques. Le système d'injection des gaz consiste en deux lignes indépendantes ; la première ligne 10 (illustrée à la fig. 1) est utilisée pour amener le mélange plasmagène dans une décharge micro-onde. Dans le présent exemple de réalisation, le mélange plasmagène est composé d'oxygène et d'argon, l'oxygène constituant le gaz réactif. La pureté des gaz utilisés est de plus de 99.995 vol%.

Le débit total des gaz injecté dans chaque tube de décharge est régulé typiquement entre 10 et 100 litre/min. La pression partielle en oxygène dans le mélange gazeux est, dans l'exemple particulier, de 10 vol%. Sous ces conditions, le plasma opère en mode luminescent (« glow mode »).

La buse 8 du tube 6 se termine par une fente rectangulaire 9 de 2 mm de haut, permettant de créer une nappe gazeuse homogène comportant les espèces actives qui va entrer en contact avec la surface du verre sous un angle contrôlé, qui peut varier de 1 à 90°.

En pratique, pour obtenir une couche sur toute la largueur d'un substrat défilant, (en particulier un ruban de verre float de plus de 3 mètres de large), il faut disposer une série de têtes d'injection 5 (et donc de cavités résonnantes 4) les unes à côté des autres pour couvrir la largeur voulue. En pratique, en suivant les paramètres décrits dans cet exemple, il faut prévoir environ une tête d'injection par 10 cm de substrat à traiter.

La deuxième ligne est utilisée pour l'injection des précurseurs dans la post-décharge du plasma. Cette deuxième ligne comporte un dispositif 11 d'amenée de gaz illustré à la fig. 2.

Dans la 2^{e} ligne d'injection de gaz, est introduit un précurseur de silice (hexaméthyldisiloxane (HMDSO), tétraéthylorthosilicate (Teos), ...). Dans le cas du HMDSO, la pureté du produit est d'environ 98%. La quantité de précurseurs vaporisés est contrôlée par un débitmètre massique liquide. Le précurseur est évaporé dans de l'argon dont le débit est fixé en fonction de la largeur du substrat à revêtir et donc en fonction du nombre de têtes d'injection 5 prévues (Suivant les paramètres donnés dans cet exemple, le débit d'argon sera de 20 litres/min multiplié par le nombre de têtes d'injection 5). De cette manière, le précurseur HMDSO est injecté à la surface du substrat par le dispositif d'amenée 11.

Le mélange Argon/HMDSO est maintenu à une température de 70°C jusqu'à son injection dans la post-décharge sortant de la buse 8. Le mélange entre les flux gazeux (post-décharge + précurseurs organométallique) se réalise au-dessus du substrat 13 dans un espace confiné formé par le substrat 13 et une voute 12 placée à quelques millimètres du substrat. Cet espace confiné forme une chambre de réaction 14. Cet espace peut éventuellement être fermé sur les côtés.

Le substrat verrier placé dans la chambre de réaction est porté à une température de 400°C. Des couches de Si02 d'épaisseur comprise entre 100 nm et 5µm ont été déposées. Ces couches sont exemptes de carbone.

## Revendications

1. Procédé pour le dépôt d'au moins une couche sur un substrat verrier inorganique (13) qui comprend les opérations suivantes :
- introduire ou faire défiler un substrat (13) dans une chambre de réaction (14) dans laquelle sont injectés au moins deux flux gazeux ; un des flux gazeux comprenant au moins un précurseur du matériau à déposer ; un autre de ces flux gazeux étant une post-décharge d'un plasma micro-onde obtenue par passage d'un mélange gazeux dans une ou plusieurs cavités résonnantes (4) alimentées par au moins un générateur micro-onde (1) ; les deux flux gazeux sont dirigés vers le substrat (13) à revêtir ;
- adapter les débits et compositions des flux gazeux et/ou la puissance du au moins un générateur micro-onde (1) en début ou en cours de procédé, de façon à obtenir des caractéristiques de réaction optimale ;
- maintenir le substrat (13) dans la chambre (14) durant un laps de temps suffisant pour obtenir une couche d'épaisseur souhaitée.

2. Procédé suivant la revendication précédente, **caractérisé en ce que** les cavités résonnantes (4) fonctionnent à une fréquence comprise entre 400 MHz et 10 GHz, de préférence comprise entre 2.40 et 2.50 GHz.

3. Procédé suivant l'une quelconque des revendications précédentes, **caractérisé en ce que** le flux gazeux alimentant la post-décharge est constitué d'un mélange d'un gaz réactif (oxygène, hydrogène, azote, etc.) et d'un gaz support (argon, hélium ou azote).

4. Procédé suivant l'une quelconque des revendications précédentes, **caractérisé en ce que** la puissance micro-onde absorbée dans chaque tube de décharge 6 varie entre 300 W et 10 kW, de préférence entre 600 W et 1200 W.

5. Procédé suivant l'une quelconque des revendications précédentes, **caractérisé en ce que** la pression partielle en gaz réactif dans le mélange gazeux constituant la post-décharge est comprise entre 1 et 50 %vol., de préférence entre 5 et 20 %vol, de manière encore préférée entre 8 et 15 %vol.

6. Procédé suivant l'une quelconque des revendications précédentes, **caractérisé en ce que** la température du substrat dans la chambre de réaction est comprise entre 20° et 1000°C, de préférence entre 100° et 750°C, et de manière encore préférée entre 300° et 600°C.

7. Installation de dépôt d'au moins une couche sur un substrat verrier inorganique (13) comprenant
- au moins une chambre de réaction (14), des moyens de transport et des moyens de support (15) pour introduire un substrat (13) dans la chambre (14) ;
- au moins un générateur micro-onde (1) alimentant une ou plusieurs cavités résonnantes (4) au travers de laquelle ou desquelles un flux gazeux est apte à circuler ; ce flux gazeux constituant la post-décharge ; un ou plusieurs autres flux gazeux transportant au moins un précurseur du matériau à déposer est (sont) également injecté(s) dans la chambre (14) mais sans passer au travers des cavités résonnantes (4) ; l'ensemble des flux gazeux est dirigé vers le substrat (13) à revêtir.

8. Installation de dépôt selon la revendication précédente, **caractérisée en ce que** chaque cavité résonnante comporte un tube de décharge (6).

9. Installation selon la revendication précédente, **caractérisée en ce que** l'ensemble des tubes de décharge (6) alimentent un dispositif (8) comportant une fente de sortie (9) permettant d'obtenir une nappe gazeuse homogène.

10. Installation selon la revendication précédente, **caractérisée en ce que** la fente (9) présente une ouverture rectangulaire de 1 à 10 mm de haut, en particulier de 2 à 6 mm.

11. Installation selon l'une quelconque des revendications 9 et 10, **caractérisée en ce que** la nappe gazeuse sortant du dispositif (8) présente un angle d'inclinaison par rapport au substrat à revêtir compris entre 1° et 90°, de préférence compris entre 20 et 80° et de manière encore préférée compris entre 40 et 70°.

12. Installation de dépôt d'au moins une couche sur un substrat non verrier (13) comprenant
- au moins une chambre de réaction (14), des moyens de transport et des moyens de support (15) pour introduire un substrat (13) dans la chambre (14) ;
- au moins un générateur micro-onde (1) alimentant une ou plusieurs cavités résonnantes (4) au travers de laquelle ou desquelles un flux gazeux est apte à circuler ; ce flux gazeux constituant la post-décharge ; un ou plusieurs autres flux gazeux transportant au moins un précurseur du matériau à déposer est (sont) également injecté(s) dans la chambre (14) mais sans passer au travers des cavités résonnantes (4) ; l'ensemble des flux gazeux est dirigé vers le substrat (13) à revêtir ;
ledit substrat non verrier (13) revêtu étant utilisé pour des applications utilisant des substrats verriers inorganiques.

13. Procédé selon l'une quelconque des revendications 1 à 6, pour le dépôt d'une couche de Si02 sur un ruban de verre float, **caractérisé en ce que** le flux de gaz de précurseurs comporte un composé de type organométallique, en particulier choisi parmi l'hexaméthyldisiloxane (HMDSO), le tétraéthylorthosilicate (Teos).

14. Procédé selon la revendication précédente, **caractérisé en ce que** le flux de gaz précurseurs comporte un mélange HMDSO/argon qui est amené dans la chambre de dépôt à une température comprise entre 30 et 100°C, de préférence entre 50 et 80°C.

15. Procédé selon l'une quelconque des revendications 13 et 14, **caractérisé en ce que** la pression partielle en gaz précurseur dans le flux de gaz précurseur est ajustée afin d'obtenir des vitesses de dépôt de Si02 comprise entre 10 et 2000 nm*m/min. et de préférence entre 500 et 1000 nm*/min.

16. Procédé pour le dépôt d'au moins une couche sur un substrat (13) non verrier qui comprend les opérations suivantes :
- introduire ou faire défiler un substrat (13) dans une chambre de réaction (14) dans laquelle sont injectés au moins deux flux gazeux ; un des flux gazeux comprenant au moins un précurseur du matériau à déposer ; un autre de ces flux gazeux étant une post-décharge d'un plasma micro-onde obtenue par passage d'un mélange gazeux dans une ou plusieurs cavités résonnantes (4) alimentées par au moins un générateur micro-onde (1) ; les deux flux gazeux sont dirigés vers le substrat (13) à revêtir ;
- adapter les débits et compositions des flux gazeux et/ou la puissance du au moins un générateur micro-onde (1) en début ou en cours de procédé, de façon à obtenir des caractéristiques de réaction optimale ;
- maintenir le substrat dans la chambre (14) durant un laps de temps suffisant pour obtenir une couche d'épaisseur souhaitée ;
ledit substrat (13) non verrier revêtu étant utilisé pour des applications utilisant des substrats verriers inorganiques.
